Europäisches Patentamt

(19) European Patent Office

Office européen des brevets

(11) Numéro de publication : **0 461 967 A2**

(12) **DEMANDE DE BREVET EUROPEEN**

(21) Numéro de dépôt : **91401492.3**

(22) Date de dépôt : **07.06.91**

(51) Int. Cl.⁵ : **H01L 29/812, H01L 21/338**

(30) Priorité : **15.06.90 FR 9007513**

(43) Date de publication de la demande :
**18.12.91 Bulletin 91/51**

(84) Etats contractants désignés :
**DE GB IT**

(71) Demandeur : **THOMSON-CSF**
**51, Esplanade du Général de Gaulle**
**F-92800 Puteaux (FR)**

(72) Inventeur : **Cachier, Gérard**
**THOMSON-CSF, SCPI, Cedex 67**
**F-92045 Paris la Defense (FR)**
Inventeur : **Gremillet, Jacques**
**THOMSON-CSF, SCPI, Cedex 67**
**F-92045 Paris la Defense (FR)**

(74) Mandataire : **Albert, Claude et al**
**THOMSON-CSF SCPI**
**F-92045 PARIS LA DEFENSE CEDEX 67 (FR)**

(54) **Composant semiconducteur à jonction Schottky pour amplification hyperfréquence et circuits logiques rapides, et procédé de réalisation d'un tel composant.**

(57)     Le composant est du type comportant : une électrode inférieure (2), formant soit émetteur ou source, soit collecteur ou drain ; une électrode centrale de commande (21, 25), formant base ou grille ; et une électrode supérieure (4), formant, respectivement, soit collecteur ou drain, soit émetteur ou source, un matériau semiconducteur (3) étant disposé entre l'électrode supérieure et l'électrode inférieure, et l'électrode de commande étant configurée au sein de ce matériau en une pluralité de doigts conducteurs adjacents définissant, dans l'intervalle transversal les séparant, au moins un canal semiconducteur (8) s'étendant verticalement entre l'électrode supérieure et l'électrode inférieure et dont la conduction est commandée par la polarisation de l'électrode de commande.

Selon l'invention, la région située, au droit des doigts, entre l'électrode de commande (21, 25) et l'électrode inférieure (2) comprend un matériau isolant (20), de manière à réduire la capacité parasite entre électrode de commande et électrode inférieure.

Très avantageusement, les doigts de l'électrode de commande (21, 25) comprenant chacun un dépôt conducteur (25) au fond d'une tranchée respective (7) creusée dans ledit matériau semiconducteur et les flancs de cette tranchée étant recouverts d'une couche de matériau de passivation (23), il est prévu entre lesdits flancs de tranchée et les flancs dudit dépôt conducteur un intervalle (27) à faible constante diélectrique, notamment constitué d'une région transversale dépourvue de matériau, de manière à réduire toute commande parasite du composant par les flancs de tranchée.

FIG.20

EP 0 461 967 A2

La présente invention concerne un composant semiconducteur à jonction Schottky, destiné aux circuits logiques rapides et à l'amplification hyperfréquence.

De nombreuses structures de composant ont déjà été proposées à cet effet, parmi lesquelles on peut citer les transistors bipolaires à homojonction, les transistors bipolaires à hétérojonction, les transistors à effet de champ MESFET (*MEtal-Silicon Field Effect Transistor*), les transistors du type dit TEGFET (*Two-dimension Electron Gas Field-Effect Transistor*) ou HEMT (*High Electron Mobility Transistor*), et les transistors du type dit à base perméable (dont la structure sera explicitée dans la suite de la présente description).

De façon générale, en hyperfréquences, on cherche à produire l'amplification maximale à la fréquence la plus élevée possible et avec une puissance de sortie la plus élevée possible. Ces trois facteurs (gain, fréquence et puissance) ne sont cependant pas indépendants, d'où nécessité de compromis et d'optimisation.

En première approximation, il est possible de dire que l'aptitude à amplifier est limitée en fréquence par la résistance série R et la capacité parallèle C d'entrée (conduisant à une constante de temps RC limitant la fréquence maximale en entrée) et par le temps de transit des porteurs de charge au sein du composant, ce temps de transit étant par ailleurs en relation directe avec la puissance disponible en sortie.

Avec les circuits logiques rapides, on peut dire, toujours en première approximation, que l'on a besoin de dispositifs à forte pente et faible capacité d'entrée et de sortie pour pouvoir travailler à des cadence d'horloge élevées.

Le transistor MESFET, dans sa structure habituelle (c'est-à-dire sa structure horizontale, où les trois électrodes de source, de grille et de drain sont sur un même plan) présente un produit RC, inhérent à cette structure, assez favorable. Mais, toujours à cause de cette structure, le temps de transit est relativement long. De plus, le fait que les trois électrodes soient sur le même plan ne facilite pas, du point de vue technologique, la mise en parallèle de transistors élémentaires - qui est cependant nécessaire pour des composants de puissance.

En outre, si les capacités d'entrée et de sortie sont relativement faibles, la transconductance est relativement élevée, ce qui influe négativement sur le produit RC d'entrée, et donc sur la fréquence maximale de travail.

Enfin, le MESFET est généralement réalisé sur arséniure de gallium, ce qui en augmente notablement la complexité de réalisation et le prix de revient.

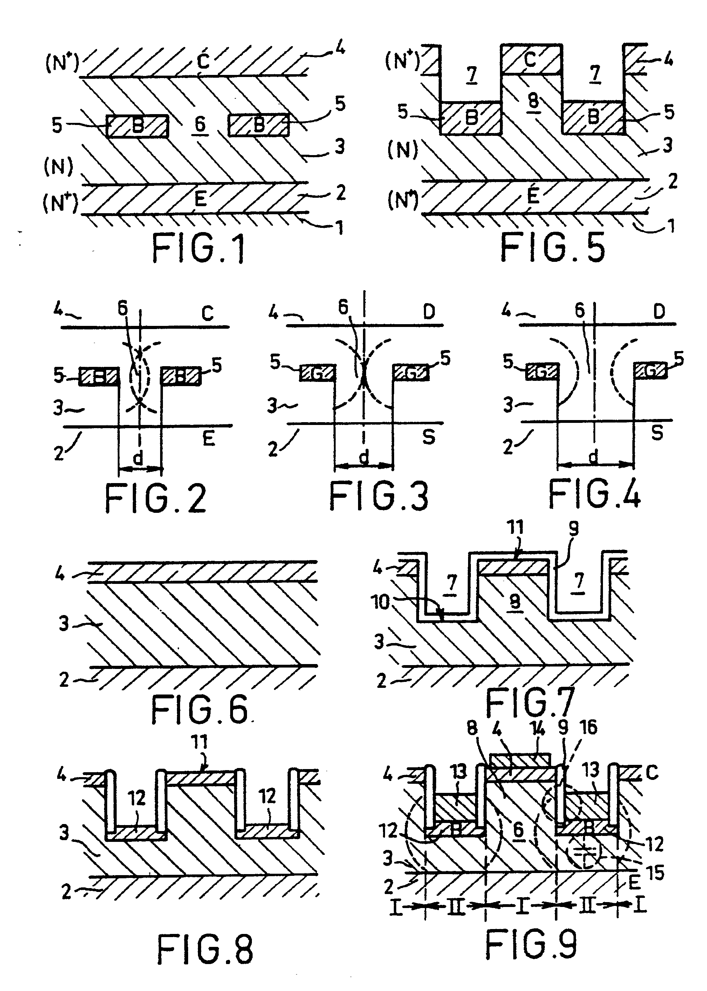

Pour remédier à ces inconvénients, on a proposé la structure dite du « transistor à base perméable » illustrée de façon schématique sur la figure 1.

Cette structure est une structure verticale à électrodes superposées comprenant, sur un substrat 1, une couche 2 fortement dopée (par exemple N⁺) puis une couche 3 faiblement dopée (par exemple N), puis une couche 4 à nouveau fortement dopée (par exemple N⁺). Au sein de la couche 3 sont enterrés, approximativement à mi-hauteur, une série d'électrodes métalliques 5 (par exemple réalisées sous la forme d'une série de doigts) interconnectées et reliées à un même potentiel.

Les différentes couches 2, 3, 4 sont formées par épitaxie, typiquement sur arséniure de gallium, le matériau de l'électrode enterrée 5 étant choisi de manière à être compatible avec cette épitaxie (on choisit par exemple le tungstène pour une épitaxie sur arséniure de gallium).

La couche 2 constitue une électrode dite d'émetteur et la couche 4 une électrode dite de collecteur (ou l'inverse ; dans toute la présente description, on considérera de façon équivalente l'une ou l'autre structure) ; l'électrode 5 constitue une électrode dite de base définissant entre collecteur 4 et émetteur 2 un canal semiconducteur 6 dont la conduction pourra être commandée par la polarisation de cette base 5, de manière à pouvoir sélectivement interdire, ou au contraire permettre, aux électrons de circuler entre collecteur et émetteur au travers des doits métalliques de la base 5 (d'où la terminologie de « base perméable »).

Le fonctionnement général d'un tel transistor à base perméable est expliqué figure 2.

Essentiellement, la polarisation de l'électrode 5 crée des zones de charge d'espace, délimitées par la courbe en tiretés sur la figure 2, et dont le recouvrement à l'endroit du canal semiconducteur 6 crée une barrière de potentiel à franchir par les électrons voulant circuler dans ce canal entre collecteur et émetteur. Le composant est commandé ainsi à la manière d'un transistor bipolaire, et c'est pourquoi les électrodes 2, 5 et 4 sont respectivement dénommées « émetteur », « base » et « collecteur ».

On notera que, si l'on augmentait l'écartement *d* entre les doigts de l'électrode 5, les zones de charge d'espace deviendraient progressivement simplement limitrophes (*d* moyenne, figure 3), avec donc une barrière de potentiel nulle pour les électrons, puis distantes (*d* grande, figure 4, ouvrant ainsi le canal conducteur 6.

Dans le premier cas (figure 3), on se trouverait dans la situation d'un MESFET (MESFET vertical) normalement bloqué, les électrodes 2, 5 et 4 correspondant respectivement à la source, à la grille et au drain, ce MESFET pouvant être rendu conducteur en polarisant l'électrode 5.

Dans le second cas (figure 4) on se trouverait dans la situation d'un MESFET normalement passant, pouvant être bloqué en polarisant l'électrode 5.

On voit que, dans ces deux cas, la commande du composant ne serait plus analogue à celle d'un transistor bipolaire comme dans le cas de la figure 2, mais serait celle d'un transistor à effet de champ.

On remarquera néammoins que, physiquement, la structure reste la même dans les trois cas, bien que le comportement électronique et donc le mode de fonctionnement (transistor à base perméable ou effet de champ) soit modifié en fonction de l'écartement $d$ — grand ou petit — des électrodes 5.

Comme on le verra par la suite, la présente invention envisagera tous les modes de fonctionnement possibles d'une telle structure ; c'est pourquoi, pour éviter toute terminologie limitative, on appellera dans la suite de la présente description l'électrode 5 (qui est une base ou une grille, selon le cas) « électrode de commande », l'électrode 2 (qui est un émetteur ou une source, selon le cas) « électrode inférieure » et l'électrode 4 (qui est un collecteur ou un drain, selon le cas) « électrode supérieure ».

On notera également que l'on pourrait tout à fait permuter le rôle des électrodes 2 et 4, l'électrode 2 étant alors le collecteur (ou le drain) et l'électrode 4 étant l'émetteur (ou la source). L'invention considérera indifféremment l'une et l'autre de ces possibilités, et la terminologie « électrode inférieure » et « électrode supérieure » a été choisie en particulier pour ne pas préjuger le rôle électrique respectif de ces deux électrodes 2 et 4.

Une autre structure connue de transistor, électriquement équivalente à celle de la figure 1, a été représentée figure 5.

Dans cette structure, l'électrode de base 5 n'est plus une électrode enterrée, mais une électrode déposée au fond d'une tranchée 7, les différentes tranchées 7 délimitant dans le matériau semiconducteur des doigts 8 définissant entre les électrodes de base 5 des canaux dont la conduction sera commandée par la polarisation de ces électrodes de base.

Un premier avantage de cette structure est de pouvoir utiliser pour la base 5 un matériau indépendant de l'épitaxie, et de pouvoir en outre accroître l'épaisseur de cette base (par exemple par enrichissement métallique), permettant ainsi d'en réduire la résistance, et donc la résistance d'entrée du composant.

En revanche, à la différence de la structure de la figure 1, cette structure est généralement réalisée non pas sur arséniure de gallium mais sur silicium. En effet, il est extrêmement délicat de réaliser des tranchées dans de l'arséniure de gallium, alors qu'on sait le faire sans difficulté dans du silicium (technique couramment utilisée pour la réalisation des mémoires vives dynamiques DRAM). De plus, on sait mal maîtriser les états de surface des flancs de tranchée dans l'arséniure de gallium, dont les irrégularités de surface provoquent le développement de zones de charge d'espace parasites. A l'opposé, on sait très facilement maîtriser les états de surface du silicium, par exemple par passivation appropriée des flancs de tranchée.

Le processus de fabrication d'un tel composant sur silicium est illustré schématiquement figures 6 à 9.

Selon ce procédé, après avoir formé par épitaxie les différentes couches 2, 3 et 4 avec les dopages appropriés (figure 6), on creuse les tranchées 7 (figure 7) de manière à laisser subsister des doigts semiconducteurs 8 et on recouvre l'ensemble d'une couche de passivation 9, par exemple de dioxyde de silicium ou de nitrure de silicium.

On procède ensuite à une gravure directionnelle de cette couche de passivation 9, de manière à mettre à nu les fonds 10 des tranchées 10 et les sommets 11 des doigts semiconducteurs, en laissant en revanche subsister la couche de passivation sur les flancs des tranchées.

On forme ensuite au fond des tranchées un dépôt métallique 12 (figure 8) permettant de constituer une jonction Schottky par obtention d'un siliciure du métal.

On dépose ensuite (figure 9) une couche d'enrichissement 13 du dépôt métallique 12 qui constituera la base du composant, de manière à en augmenter l'épaisseur et d'en réduire la résistance d'électrode correspondante (et donc le produit RC d'entrée du composant). On dépose également au sommet des doigts semiconducteurs 8 une métallisation 14 qui permettra d'assurer la prise de connexion à la couche 4 constituant l'électrode de collecteur.

Cette structure, bien que relativement aisée à réaliser sur silicium, présente un certain nombre d'inconvénients.

En premier lieu, on peut remarquer que la structure, essentiellement, se compose d'une juxtaposition de régions utiles (repérées $I$ sur la figure 9), c'est-à-dire de régions ou circulent les électrons (canal 6, défini dans la région des doigts semiconducteurs 8, dont la conduction est contrôlée par la polarisation des électrodes de base 12) et de régions parasites, repérées $II$ sur la figure 9, qui sont les régions situées au droit des électrodes de base 12 : en effet, ces dernières régions ne jouent aucun rôle du point de vue électronique, puisque la conduction contrôlée s'effectue entre les électrodes 12 et non au droit de celle-ci.

Ces zone $II$ sont d'ailleurs doublement parasites.

En premier lieu, la zone repérée 15, c'est-à-dire la zone située sous la base 12, entre cette dernière et l'émetteur 2, introduit une capacité parasite venant dégrader le produit RC d'entrée et limitant donc de façon corrélative la fréquence maximale de travail du composant.

En second lieu, la zone repérée 16, c'est-à-dire la zone située entre le flanc de tranchée et le dépôt d'enrichissement métallique 13, peut introduire une commande parasite appliquée au composant, les couches successives métallisation 13/couche de passivation 9/semiconducteur de la région 8 se comportant alors comme une structure de type MIS (Métal-Isolant-Silicium) ou MOS (si l'isolant de passivation est un oxyde) susceptible de produire un déclenchement indésirable du composant.

Cette zone 16 introduit également, outre la possibilité de commande parasite, une capacité base/collecteur entre la métallisation 13 et la couche semiconductrice supérieure 4. Cette capacité, bien que réduite par rapport à la structure à base enterrée (structure de la figure 1), reste encore relativement importante.

L'invention a pour but de remédier à l'ensemble des inconvénients précités, en proposant un composant qui pallie les limitations que l'on vient d'exposer des composants de l'art antérieur, notamment des transistors à base perméable.

Un premier but de l'invention est de minimiser la capacité d'entrée du composant en réduisant dans des proportions importantes la capacité parasite entre base et émetteur, ce qui autorisera une fréquence de travail très supérieure (car, on le verra, on conserve la faible résistance d'entrée procurée par l'enrichissement métallique de la base).

Un second but de la présente invention est de remédier au risque de commande parasite par effet MIS rencontré avec ces composants, c'est-à-dire au risque de commande indésirable du composant par les flancs de tranchée.

Un troisième but de l'invention est de proposer une structure qui permette, en outre, de relier ensemble une pluralité de composants élémentaires réalisés sur un même substrat en prévoyant des circuits de préadaptation d'impédance, directement réalisés sur ce substrat, pour optimiser l'impédance globale d'entrée et/ou de sortie des différents composants élémentaires ainsi combinés.

Un quatrième but de l'invention est de proposer une structure qui permette, en outre, d'intégrer aisément au composant une électrode supplémentaire permettant de remédier à l'effet Miller (l'effet Miller est un effet classique rencontré dans tous les étages amplificateurs à tubes électroniques et à transistors à effet de champ, et par lequel la capacité de rétroaction est ramenée à l'entrée multipliée par un facteur g+1, g étant le gain de l'étage amplificateur; cet effet a donc pour résultat d'augmenter considérablement la capacité d'entrée si on ne procède pas à sa compensation ou « neutrodynage »).

Un cinquième but de l'invention est de proposer une structure qui puisse être indifféremment réalisée soit directement sur un substrat semiconducteur (typiquement, par mise en oeuvre d'une technologie de type *mesa*), soit sur un substrat à forte résistivité, l'accès à l'électrode inférieure interne se faisant alors par des vias, technologie bien connue en elle-même.

Un sixième but de l'invention est de proposer un composant dont le mode de fonctionnement puisse être aussi bien un fonctionnement en transistor à base perméable (comme expliqué plus haut à propos de la figure 2) qu'en transistor MESFET vertical (comme expliqué plus haut à propos des figures 3 et 4), avec même possibilité de fonctionnement mixte, c'est-à-dire un fonctionnement en transistor à base perméable pendant une partie du cycle et en MESFET pendant le reste du cycle. On pourra ainsi combiner de façon optimale, en fonction des besoins et selon le point de fonctionnement, les avantages propres du transistor à base perméable (excellente transconductance, excellentes caractéristiques de gain et de fréquence) et ceux du MESFET (impédance d'entrée plus élevée, donc plus facile à adapter, et plus grandes intensités possibles donc meilleure tenue en puissance).

Un septième but de l'invention, est, enfin, de permettre (mais de façon facultative) la réalisation d'un tel composant sur silicium, donc avec des techniques aisées à mettre en oeuvre, tout en bénéficiant de performances aussi bonnes, sinon meilleures, que les composants actuels de même type réalisés sur arséniure de gallium. Par ailleurs, outre la technologie plus aisée à mettre en oeuvre, le silicium présente l'avantage de présenter une conductivité thermique excellente (trois à quatre fois meilleure que les composés III-V tel que l'arséniure de gallium) de sorte que, pour une même puissance dissipée, la température de fonctionnement sera nettement plus faible, permettant ainsi d'accroître notablement la fiabilité du composant (ou, inversement, pour une même température de fonctionnement, la puissance dissipable pourra être très supérieure) ; ce dernier avantage est d'autant plus intéressant que, comme on le verra, le composant de l'invention se prête particulièrement bien à la réalisation de composants hyperfréquence de puissance.

A cet effet, la présente invention propose un composant semiconducteur à jonction Schottky du type général correspondant à la structure illustrée figure 5, c'est-à-dire une structure à électrodes superposées comportant, successivement : une électrode inférieure, formant soit émetteur ou source, soit collecteur ou drain ; une électrode centrale de commande, formant base ou grille ; et une électrode inférieure, formant, respectivement, soit collecteur ou drain, soit émetteur ou source; un matériau semiconducteur étant disposé entre l'électrode supérieure et l'électrode inférieure, et l'électrode de commande étant configurée au sein de ce matériau en une pluralité de doigts conducteurs adjacents définissant, dans l'intervalle transversal les séparant, au moins un canal semiconducteur s'étendant verticalement entre l'électrode supérieure et l'électrode inférieure et dont la conduction est commandée par la polarisation de l'électrode de commande.

Selon l'invention, la région située, au droit des doigts, entre l'électrode de commande et l'électrode inférieure comprend un matériau isolant, de manière à réduire la capacité parasite entre électrode de commande et électrode inférieure.

Le matériau isolant présent entre électrode de commande et électrode inférieure peut notamment être un matériau du groupe comprenant les polyimides, l'oxyde de silicium, le nitrure de silicium et l'oxynitrure de silicium.

Selon une autre caractéristique particulièrement avantageuse de l'invention, les doigts de l'électrode de commande étant formés chacun par un dépôt conducteur au fond d'une tranchée respective creusée dans ledit matériau semiconducteur et les flancs de cette tranchée étant recouverts d'une couche de matériau de passivation, il est prévu entre lesdits flancs de tranchée et les flancs dudit dépôt conducteur un intervalle à faible constante diélectrique, de manière à empêcher toute commande parasite du composant par les flancs de tranchée ; cet intervalle à faible constante diélectrique peut notamment être constitué d'une région transversale dépourvue de matériau.

Il peut être en outre avantageusement prévu, entre l'électrode de commande et l'une des électrodes supérieure ou inférieure, une électrode supplémentaire formant écran, de manière à permettre la réduction de l'effet Miller.

Ledit matériau semiconducteur est de préférence un silicium faiblement dopé, les électrodes supérieure et inférieure étant en silicium fortement dopé de même type de conductivité que le silicium du matériau semiconducteur.

Dans une première forme de réalisation, l'électrode inférieure peut alors être constituée par le substrat même du composant.

Dans une seconde forme de réalisation, l'électrode inférieure peut au contraire être formée par une couche épitaxiée sur un substrat de silicium quasi-intrinsèque de forte résistivité, des moyens étant alors prévus pour assurer la prise de contact à l'électrode inférieure au travers de ce substrat de forte résistivité.

Le composant ainsi obtenu peut notamment être interconnecté avec d'autres composants semblables.

Il est alors très avantageusement prévu des circuits de préadaptation d'impédance d'entrée, formés par une combinaison de sections inductives et de sections capacitives des conducteurs de liaison aux différents doigts conducteurs constituant l'électrode de commande du composant ainsi que, le cas échéant, d'une combinaison de sections inductives et de sections capacitives des conducteurs d'interconnexion des électrodes de commande d'autres composants réalisés sur le même substrat, de manière à compenser la désadaptation d'impédance résultant de la mise en parallèle des différents doigts conducteurs d'un même composant et/ou la désadaptation d'impédance résultant de la mise en parallèle de plusieurs composants réalisés sur le même substrat.

En complément, des circuits de préadaptation d'impédance de sortie peuvent être formés de la même manière, par une combinaison de sections inductives et de sections capacitives des conducteurs de liaison aux différentes plages conductrices constituant l'électrode supérieure du composant ainsi que, le cas échéant, d'une combinaison de sections inductives et de sections capacitives des conducteurs d'interconnexion des électrodes supérieures d'autres composants réalisés sur le même substrat, de manière à compenser la désadaptation d'impédance résultant de la mise en parallèle des différentes différentes plages conductrices d'un même composant et/ou la désadaptation d'impédance résultant de la mise en parallèle de plusieurs composants réalisés sur le même substrat.

La présente invention propose également un procédé de réalisation d'un composant selon l'une des revendications précédentes, comprenant les étapes consistant à:

(a) former sur un substrat une structure en superposition comprenant successivement une électrode inférieure, une couche de matériau semiconducteur et une électrode supérieure,

(b) graver dans cette structure des tranchées de profondeur telle qu'elles entament au moins partiellement l'épaisseur de l'électrode inférieure,

(c) remplir les tranchées ainsi formées par un matériau isolant,

(d) éliminer partiellement le matériau isolant ainsi déposé jusqu'à une profondeur de tranchée située à un niveau médian de la couche de matériau semiconducteur,

(e) déposer dans la tranchée, sur la région apparente du matériau isolant audit niveau médian, une métallisation formant électrode de commande, et

(f) passiver les flancs de la tranchée au-dessus de la métallisation ainsi déposée.

Pour diminuer la résistance de l'électrode de commande et donc la résistance d'entrée du composant, l'étape (f) ci-dessus peut notamment comprendre les étapes consistant à:

(f1) déposer, sur les bancs et le fond de la tranchée, au moins une couche de matériau de passivation,

(f2) graver sélectivement les zones horizontales de cette couche de matériau de passivation, de manière à laisser paraître au fond de la tranchée la métallisation sous-jacente,

(f3) déposer sur cette métallisation apparente une couche de matériau d'enrichissement métallique.

Très avantageusement, pour supprimer les risques de commande MIS parasite du composant par les flancs de tranchée:

– au cours de l'étape (f1), on dépose successivement un premier de passivation puis un second matériau de passivation, différent du premier, et

– après l'étape (f3), il est prévu une étape (f4) consistant à éliminer le second matériau de passivation de manière à laisser subsister, entre les flancs de la tranchée et les flancs dudit matériau d'enrichissement métallique, un intervalle dépourvu de matériau.

Le matériau isolant mentionné ci-dessus est de préférence un matériau du groupe comprenant les polyimides, l'oxyde de silicium, le nitrure de silicium et l'oxynitrure de silicium.

Si l'on souhaite réaliser une structure de tétrode permettant d'assurer la réduction de l'effet Miller du composant, on prévoit également, après l'étape (f), les étapes consistant à :

(g) remplir à nouveau les tranchées par un matériau isolant,

(h) éliminer partiellement le matériau isolant ainsi déposé jusqu'à une profondeur de tranchée située à un niveau intermédiaire entre ledit niveau médian de la couche de matériau semiconducteur et le niveau de l'électrode supérieure,

(i) déposer dans la tranchée, sur la région apparente du matériau isolant audit niveau intermédiaire, une seconde métallisation formant électrode d'écran.

Si l'on souhaite réaliser par le procédé de l'invention la première forme de réalisation précitée, on prévoit alors que, dans ce procédé, ladite structure est une structure formée par épitaxie de silicium, ledit matériau semiconducteur étant faiblement dopé, et les électrodes supérieure et inférieure étant fortement dopées et de même type de conductivité que le matériau semiconducteur, et l'électrode inférieure est constituée par le substrat même du composant.

Si l'on souhaite réaliser par le procédé de l'invention la première forme de réalisation précitée, on prévoit alors que, dans ce procédé, ladite structure est une structure formée par épitaxie de silicium sur un substrat de silicium quasi-intrinsèque de forte résistivité, ledit matériau semiconducteur étant faiblement dopé, et les électrodes supérieure et inférieure étant fortement dopées et de même type de conductivité que le matériau semiconducteur.

Dans ce cas, pour assurer la prise de connexion à l'électrode inférieure, il convient de prévoir également les étapes consistant à former au dos du substrat des vias sur une profondeur permettant d'atteindre l'électrode inférieure, et déposer dans ces vias une métallisation permettant d'assurer la prise de connexion à cette électrode.

Si l'on souhaite réaliser par le procédé de l'invention les circuits de préadaptation d'impédance d'entrée précités, il convient de prévoir également une étape de gravure sélective des métallisations formant les électrodes de commande, de manière à former une combinaison de sections inductives et de sections capacitives de ces électrodes de commande ainsi que, le cas échéant, une combinaison de sections inductives et de sections capacitives des conducteurs d'interconnexion des électrodes de commande d'autres composants réalisés sur le même substrat.

Si l'on souhaite, de la même façon, réaliser en outre par le procédé de l'invention les circuits de préadaptation d'impédance de sortie précités, il convient de prévoir également une étape de gravure sélective des métallisations formant les électrodes supérieures, de manière à former une combinaison de sections inductives et de sections capacitives des conducteurs de liaison de ces électrodes supérieures ainsi que, le cas échéant, une combinaison de sections inductives et de sections capacitives des conducteurs d'interconnexion des électrodes supérieures d'autres composants réalisés sur le même substrat.

On va maintenant donner des exemples de réalisation du composant de l'invention et de mise en oeuvre de son procédé de fabrication, en référence aux dessins annexés.

La figure 1, précitée, illustre de façon schématique la structure de base d'un transistor à base perméable de l'art antérieur.

Les figures 2 à 4, précitées, illustrent les divers modes de fonctionnement possibles du composant de la figure 1, en fonction de la largeur des intervalles définis entre les éléments métalliques de la base.

La figure 5, précitée, représente une variante, toujours selon l'art antérieur, du composant de la figure 1 dans laquelle, au lieu d'enterrer les bases, on forme celles-ci au fond de tranchées.

Les figures 6 à 9, précitées, illustrent les diverses étapes du procédé de fabrication du composant de la figure 5.

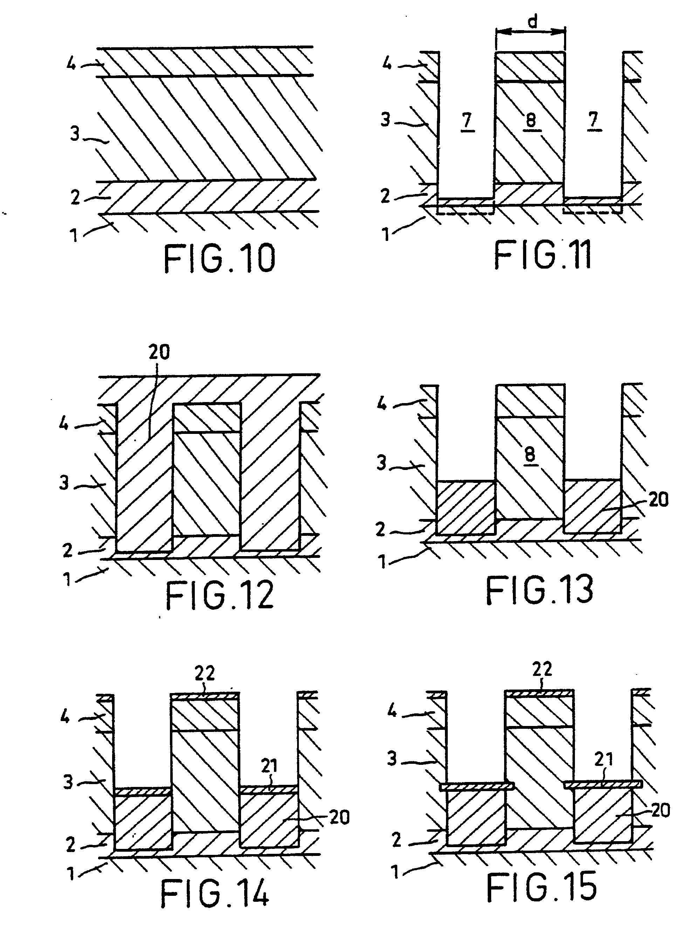

Les figures 10 à 20 illustrent les diverses étapes successives d'un procédé de réalisation d'un composant élémentaire selon l'invention.

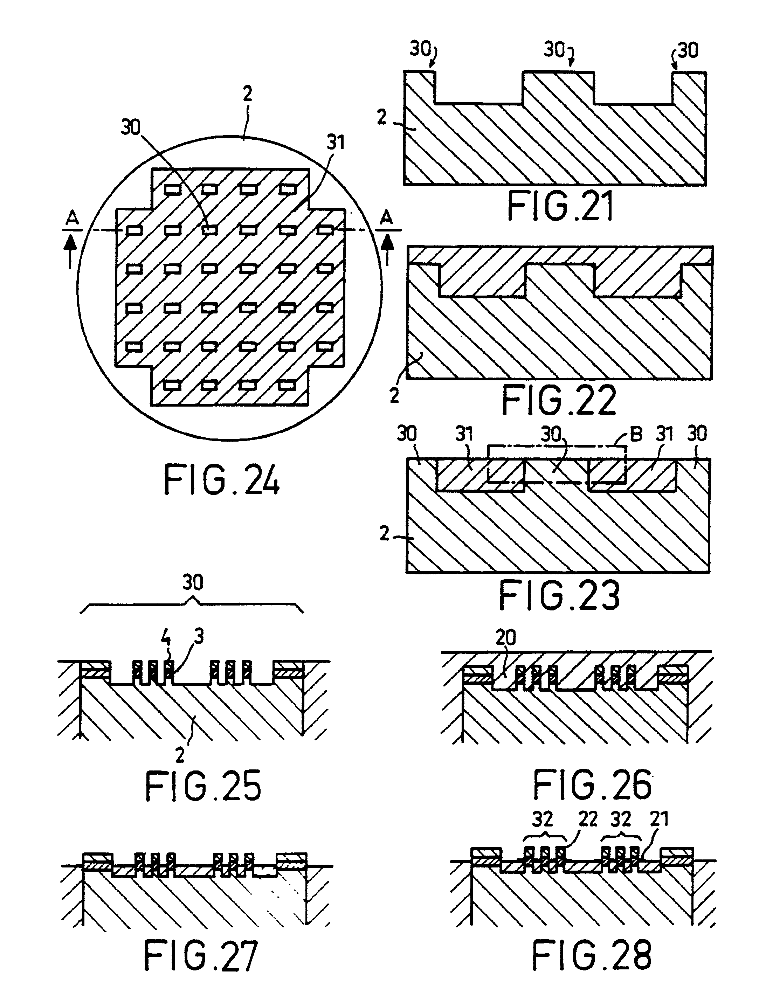

Les figures 21 à 28 illustrent les diverses étapes successives d'un procédé de réalisation d'un ensemble de composants élémentaires réalisés sur un même substrat.

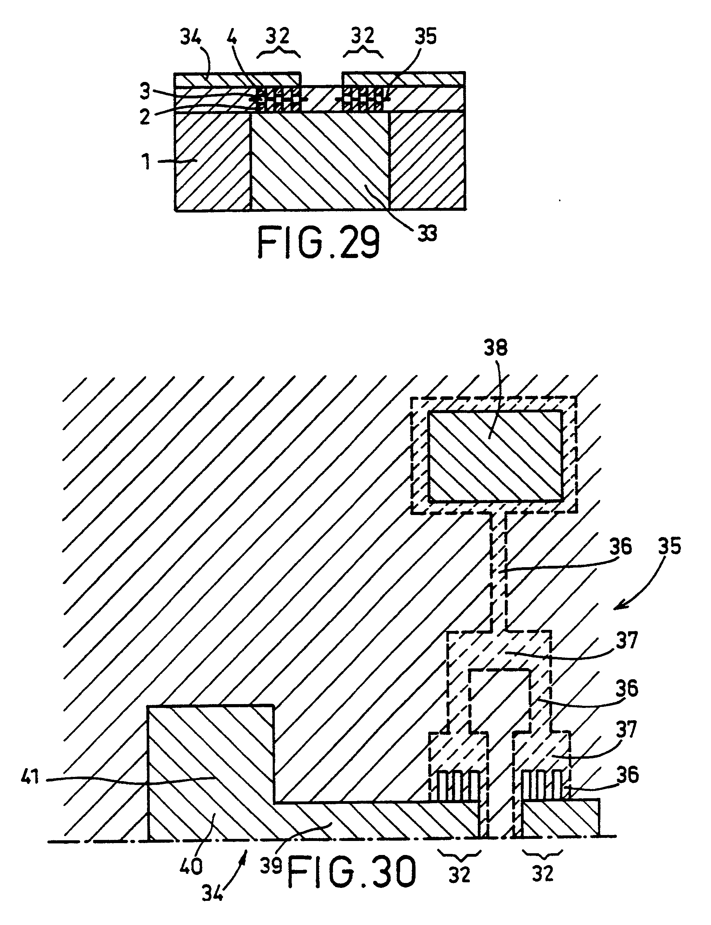

La figure 29 illustre une variante de la mise en oeuvre précédente, dans laquelle les composants sont réalisés sur un substrat à haute résistivité au lieu de l'être sur un substrat semiconducteur.

La figure 30 montre la manière d'interconnecter entre eux plusieurs composants élémentaires réalisés sur un même substrat, en réalisant en outre la pré-adaptation d'impédance d'entrée et de sortie au moyen d'éléments inductifs et capacitifs intégrés au substrat lors du processus de fabrication.

On a illustré sur les figures 10 à 20 les différentes étapes de réalisation d'un composant selon l'invention, le composant final obtenu, intégrant toutes les caractéristiques proposées par l'invention, étant représenté figure 20.

On va d'abord décrire le processus de fabrication de ce composant, dont on exposera ensuite, en référence à cette figure 20, les caractéristiques propres.

Tout d'abord (figure 10), on forme, de façon en elle-même classique, sur un substrat 1 une superposition de couches 2, 3, 4, typiquement par épitaxie de silicium (l'emploi du silicium n'étant cependant pas limitatif).

La séquence des couches 2, 3, 4, est, typiquement, une séquence N⁺, N, N⁺, comme dans les transistors à base perméable de l'art antérieur. On pourrait cependant, aussi bien, envisager une séquence P⁺, P, P⁺, toute les autres étapes étant les mêmes ; on obtiendrait ainsi un transistor de type complémentaire de celui décrit.

On notera que la couche centrale N n'est pas nécessairement homogène ; elle peut notamment présenter, entre les deux couches N⁺, un dopage variable.

On notera également que le substrat 1 peut être soit constitué par la couche N⁺ elle-même (les deux couches 1 et 2 sont alors confondues), permettant ainsi de prendre directement le contact à l'électrode inférieure formée par la couche 2, soit un substrat fortement résistant (résistivité supérieure à 2000 $\Omega$.cm) tel qu'un substrat de silicium quasi-intrinsèque ; dans ce dernier cas, la couche 2 de l'électrode inférieure est une couche enterrée, et il faudra assurer la prise de contact par un via traversant le substrat et rempli d'un matériau conducteur, comme on le décrira plus loin à propos de la figure 29.

On procède ensuite (figure 11 ) à la gravure des tranchées 7, qui laissent subsister entre elles des doigts semiconducteurs 8.

La gravure est réalisée par des procédés classiques en eux-mêmes, par exemple par gravure ionique réactive.

De façon caractéristique de l'invention, la gravure des tranchées est faite plus profonde que le niveau prévu ultérieurement pour la jonction Schottky (comparer cette figure 11 à la figure 7, correspondant à la technique de l'art antérieur). La gravure atteint ainsi la couche inférieure 2, comme illustré figure 11, et elle peut même aller jusqu'au substrat, voire y pénétrer (comme suggéré en tiretés sur la figure 11 ).

La largeur des tranchées 7 pourra être différente de celle des doigts 8, en particulier supérieure ; on verra plus loin de quelle manière la largeur *d* du doigt semiconducteur conditionne le mode de fonctionnement du composant final obtenu.

On comble ensuite (figure 12) les tranchées par un isolant 20. Cet isolant peut être un oxyde de silicium, un nitrure de silicium ou un polyimide, déposés par un procédé connu, par exemple de dépôt en phase vapeur assisté ou non par plasma.

On procède ensuite (figure 13) à une élimination partielle de cet isolant 20 jusqu'au niveau prévu pour la jonction Schottky. Comme on peut le voir, on met ainsi à nu les parois des doigts semiconducteurs 8 dans toute la région où l'isolant a été éliminé.

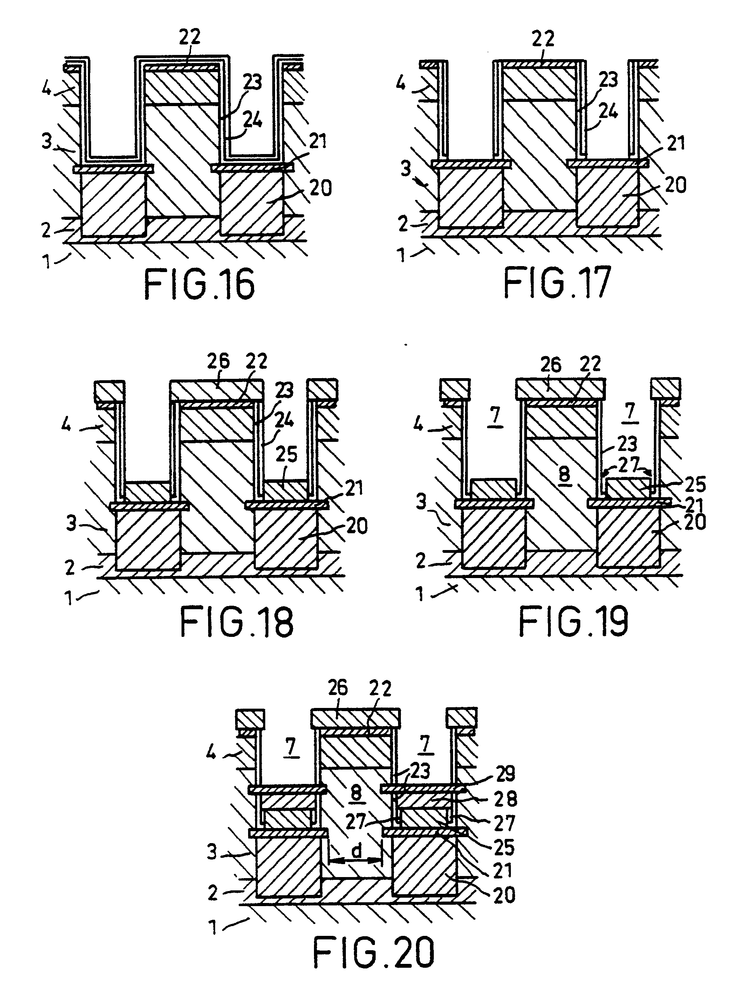

On dépose ensuite (figure 14) une fine couche métallique, d'épaisseur de l'ordre de 20 à 50 nm, définissant l'emplacement de la jonction Schottky qui sera réalisée à l'étape suivante et définissant également, comme on le verra par la suite, les interconnexions de mise en parallèle des différentes électrodes de commande d'un même composant élémentaire ainsi que, le cas échéant, de mise en parallèle des différents transistors élémentaires réalisés sur un même substrat.

Le métal peut être par exemple le tungstène, le cobalt, ou le platine.

Outre le dépôt 21 au fond des tranchées, le métal est également déposé en 22 au sommet des doigts semiconducteurs afin de permettre la prise de contact ultérieur à l'électrode supérieure définie par la couche 4 (et, de la même façon, l'interconnexion des différentes électrodes supérieures entre elles).

Ensuite (figure 15), après nettoyage en surface des bancs de tranchée, on réalise la jonction Schottky par formation d'un siliciure du métal déposé en 21 à l'étape précédente.

On voit déjà que, à ce stade, on a déjà réalisé la réduction de la capacité de chaque côté de la métallisation de l'électrode de commande 21, c'est-à-dire à la fois au-dessus de cette électrode, du fait que l'on prévoit des tranchées au lieu de l'électrode enterrée (de manière connue, comme sur la figure 5) mais aussi — de façon caractéristique de l'invention — au-dessous de cette électrode, car la capacité sous la métallisation 21 n'est plus celle d'une jonction (comme dans l'art antérieur, tel qu'illustré figure 5), mais celle résultant de la présence du diélectrique constitué par l'isolant 20, c'est-à-dire au moins trois fois plus faible.

Après cette étape, on procède alors (figure 16), à un dépôt chimique en phase vapeur, assisté ou non par plasma, de deux couches successives de passivation 23 et 24 constituées d'isolants différents, par exemple d'oxyde de silicium puis de nitrure de silicium, ou l'inverse.

On effectue ensuite la gravure (figure 17) des zones planes horizontales, par exemple par attaque ionique réactive, de manière à ne laisser subsister les deux couches de passivation 23 et 24 que sur les flancs de tranchée, en mettant à nu les métallisations 21 et 22.

Ces métallisations 21 et 22 sont alors (figure 18) enrichies par un dépôt métallique respectif 25 et 26, par exemple d'aluminium et/ou d'or.

On élimine alors (figure 19) par attaque chimique sélective la deuxième couche d'isolant 24, de manière à ne laisser subsister que la première couche de passivation 23.

Cette manière de procéder permet de laisser subsister, entre les faces latérales de la métallisation 25 de l'électrode de commande et les flancs de tranchée, un vide 27 permettant de réduire considérablement les risques de commande parasite MIS. En effet, la constante diélectrique de ce vide 27 est $\varepsilon_0 = 1$, valeur très.inférieure à la constante diélectrique $\varepsilon \approx 4$ des matériaux de passivation habituellement utilisés tels que l'oxyde de silicium ou le nitrure de silicium.

La passivation des flancs de tranchée reste néanmoins assurée par la première couche subsistante 23.

Le composant ainsi réalisé, illustré figure 19, peut être utilisé tel quel mais on peut avantageusement, comme illustré figure 20, former une deuxième jonction Schottky au-dessus de la première, en rééditant le même processus.

A cet effet, on procède à un deuxième dépôt d'isolant 28 au-dessus de la métallisation 25 et on forme une seconde jonction Schottky (dépôt d'une fine couche métallique puis formation d'un siliciure de ce métal) de la même manière que pour la jonction Schottky 21.

L'électrode 29 ainsi obtenue, convenablement polarisée, pourra constituer un écran électrostatique, interposé entre l'électrode de commande 21, 25 et l'électrode supérieure 22, 26, assurant une réduction de la capacité entre ces deux électrodes. Si le composant est utilisé en amplification, on peut ainsi limiter très fortement l'effet Miller mentionné plus haut, qui apparait classiquement avec les composants de ce type.

En d'autres termes, cet écran permet de transformer la structure triode en une structure tétrode.

On notera que les deux électrodes (électrode de commande et électrode d'écran) peuvent être permutées selon la position de l'électrode de référence (collecteur) qui, comme on l'a indiqué au début de la présente description, peut être aussi bien au substrat (couche inférieure 2) qu'en haut des doigts (couche supérieure 4).

D'autre part, lors de la conception du composant, on choisira le dopage et la largeur $d$ du canal semiconducteur en fonction du mode de fonctionnement que l'on voudra obtenir pour le composant.

Plus précisément, pour un dopage $n$ donné, lorsque l'on fait varier la largeur $d$ du canal défini par la largeur du doigt de semiconducteur 8, on passe de façon continue d'un fonctionnement en transistor à base perméable (très faible largeur de doigt) à un fonctionnement en MESFET vertical (plus grande largeur de doigt), la transition entre les deux modes se situant autour de valeurs de $n$ et $d$ telles que :

$$n.d^2 = (8\varepsilon/q)\,\phi,$$

$\varepsilon$ étant la constante diélectrique du semiconducteur, q étant la charge de l'électron ($1,6\ 10^{-19}$ C) et $\phi$ étant le potentiel de contact de la jonction Schottky.

Afin d'optimiser les problèmes de technologie (largeur des doigts) et ceux de circuit (impédances d'entrée et de sortie, tension de déchet), on pourra se mettre au voisinage des valeurs de $n$ et $d$ définies par l'équation ci-dessus, réalisant ainsi un transistor qui ne sera à proprement parler ni un transistor à base perméable ni un MESFET, puisqu'il se comportera comme un MESFET pour une polarisation nulle de l'électrode de commande par rapport à l'électrode de référence (électrode inférieure) et comme un transistor à base perméable pour des polarisations voisines du blocage du transistor.

Par ailleurs, comme on l'a expliqué plus haut, un important intérêt de la structure est de pouvoir être réalisée et fonctionner en utilisant le silicium comme semiconducteur. Cependant, celui-ci n'offre pas, contrairement à l'arséniure de gallium, de substrat semi-isolant.

Aussi, afin de pouvoir prendre les contacts et réaliser les circuits d'interconnexion et de préadaptation (voir plus loin) de l'électrode de commande, on peut réaliser le composant en utilisant des structures de type « mesa » pour les composants élémentaires et des dépôts d'isolant en couche assez épaisse (quelques micromètres à quelques dizaines de micromètres) autour des mesas pour résoudre ce problème.

Cette technique correspond aux étapes de processus illustrées figures 21 à 28.

Sur une plaquette de semiconducteur, on grave (figure 21 ) une suite d'îlots 30 dans lesquels seront formés un ou plusieurs composants élémentaires. La profondeur de la gravure peut être comprise entre quelques micromètres et quelques dizaines de micromètres.

La gravure est ensuite comblée (figure 22) par un isolant, par exemple du dioxyde de silicium.

On remet ensuite (figure 23) à nu en surface le semiconducteur, par exemple par polissage mécanochimique, ce qui permet de faire réapparaitre les îlots 30, isolés les uns des autres par la masse d'isolant 31. En plan, la tranche a alors l'aspect illustré figure 24, la figure 23 correspondant à une coupe selon la ligne A-A.

On procède alors à l'exécution des différentes étapes décrites plus haut à propos des figures 10 à 20 sur chacun des îlots 30, qui ont été représentés sous forme agrandie sur les figures 27 à 28 (cet agrandissement correspondant à la région repérée B sur la figure 23).

On a ainsi représenté sur la figure 25 une vue en coupe d'un îlot après gravure des doigts. L'îlot est ici supposé comporter deux transistors élémentaires de trois doigts chacun (la mise en parallèle de ces transistors élémentaires donnant le transistor final complet). Cette étape illustrée figure 25 correspond à l'étape de la figure 11, explicitée plus haut.

Les figures 26 (comblement des gravures par de l'isolant) et 27 (mise à niveau de cet isolant) correspondent, respectivement, aux étapes des figures 12 et 13 décrites plus haut, et ne seront donc pas développées plus en détail.

La figure 28 correspond au stade du processus après dépôt des métallisations de fond de tranchée 21 et de sommet de doigt 22 (figure 17 décrite ci-dessus).

Les différentes métallisations 21 et 22 sont configurées de manière à assurer la mise en parallèle de toutes les électrodes de commande (et, de même, de toutes les électrodes supérieures) d'un même composant élémentaire, repéré 32 sur la figure 28. On verra également que ces métallisations peuvent en outre, par une configuration particulière, assurer non seulement l'interconnexion mais également la préadaptation d'impédance, aussi bien en entrée et en sortie (voir plus loin les explications données à propos de la figure 30) du composant final constitué par les différents composants élémentaires interconnectés sur le même substrat.

Dans une autre forme de mise en oeuvre du procédé de l'invention, pour pallier le fait que (contrairement à l'arséniure de gallium) le silicium n'offre pas de substrat semi-isolant, on peut travailler avec du silicium quasi intrinsèque comme substrat (résistivité de 2000 à 10 000 Ω.cm).

Ceci est illustré figure 29, qui est une vue en coupe du substrat portant deux transistors élémentaires réalisés selon cette technologie.

On voit sur cette figure que l'accès à la couche inférieure semiconductrice 2 est effectuée, de façon collective pour tous les composants, par un via 33 traversant le substrat de silicium quasi-intrinsèque 1 sur toute son épaisseur.

Les électrodes supérieures (couche 4) des différents composants individuels sont réunies ensemble par une métallisation 34 assurant la mise en parallèle des différents composants élémentaires.

Vues de dessus, les différentes liaisons électriques entre électrodes sont illustrées figure 30 où l'on peut voir, outre les circuits d'interconnexion proprement dits, des circuits de préadaptation d'impédance directement intégrés lors des différentes étapes de réalisation du composant.

En effet, la mise en parallèle de plusieurs composants élémentaires, si elle était faite sans précaution particulière, résulterait en une diminution considérable de l'impédance : par exemple, la mise en parallèle de dix composants présentant une impédance unitaire de 10 Ω chacun aboutirait à une impédance totale de 1Ω, très inférieure aux valeurs habituelles typiques en hyperfréquences (25 à 70 Ω).

On notera que, sur cette figure, on n'a représenté que l'interconnexion de deux transistors élémentaires 32, mais que l'on peut généraliser cette technique à un nombre plus élevé (une dizaine, ou même plusieurs dizaines) de composants élémentaires, en fonction de la puissance de sortie recherchée.

A cet effet, la métallisation 35 qui assure l'interconnexion des différentes électrodes de commande des composants élémentaires 32 est configurée en une succession d'éléments longs et étroits 36 et d'éléments courts et larges 37 constituant respectivement, du point de vue électrique, des éléments inductifs et des éléments capacitifs.

La ligne constituée de ces éléments successivement inductifs et capacitifs 36, 37, dont les valeurs ont été calculées de façon appropriée en fonction du nombre de composants à coupler en parallèle et de l'impédance caractéristique globale souhaitée, permet de ramener sur le contact collectif 38 une impédance de valeur compatible avec les circuits d'entrée utilisés.

De la même façon, il est possible de réaliser une préadaptation de l'impédance de sortie en configurant de façon appropriée la métallisation 34 servant à la mise en parallèle des électrodes supérieures des différents composants élémentaires, cette métallisation comportant alors des tronçons inductifs tels que 39 et capacitifs tels que 40 pour la liaison du contact commun correspondant 41 aux électrodes homologues des divers composants élémentaires.

## Revendications

1.  Un composant semiconducteur à jonction Schottky à électrodes superposées, comportant successivement:
    – une électrode inférieure (2), formant soit émetteur ou source, soit collecteur ou drain,
    – une électrode centrale de commande (5 ; 21, 25), formant base ou grille, et
    – une électrode supérieure (4), formant, respectivement, soit collecteur ou drain, soit émetteur ou source,
    un matériau semiconducteur (3) étant disposé entre l'électrode supérieure et l'électrode inférieure, et l'électrode de commande étant configurée au sein de ce matériau en une pluralité de doigts conducteurs adjacents définissant, dans l'intervalle transversal les séparant, au moins un canal semiconducteur (8) s'étendant verticalement entre l'électrode supérieure et l'électrode inférieure et dont la conduction est commandée par la polarisation de l'électrode de commande,
    caractérisé en ce que la région située, au droit des doigts, entre l'électrode de commande (21, 25) et l'électrode inférieure (2) comprend un matériau isolant (20), de manière à réduire la capacité parasite entre électrode de commande et électrode inférieure.

2.  Le composant semiconducteur de la revendication 1, dans lequel ledit matériau isolant (20) présent entre électrode de commande et électrode inférieure est un matériau du groupe comprenant les polyimides, l'oxyde de silicium, le nitrure de silicium et l'oxynitrure de silicium.

3. Le composant semiconducteur de la revendication 1, dans lequel, les doigts de l'électrode de commande (21, 25) comprenant chacun un dépôt conducteur (25) au fond d'une tranchée respective (7) creusée dans ledit matériau semiconducteur et les flancs de cette tranchée étant recouverts d'une couche de matériau de passivation (23), il est prévu entre lesdits flancs de tranchée et les flancs dudit dépôt conducteur un intervalle (27) à faible constante diélectrique, de manière à empêcher toute commande parasite du composant par les flancs de tranchée.

4. Le composant semiconducteur de la revendication 3, dans lequel ledit intervalle à faible constante diélectrique (27) est constitue d'une région transversale dépourvue de matériau.

5. Le composant semiconducteur de la revendication 1, dans lequel il est prévu en outre, entre l'électrode de commande (21, 25) et l'une des électrodes supérieure ou inférieure, une électrode supplémentaire (29) formant écran, de manière à réduire l'effet Miller sur l'étage amplificateur constitue par le composant.

6. Le composant semiconducteur de la revendication 1, dans lequel ledit matériau semiconducteur (3) est un silicium faiblement dope, les électrodes supérieure (4) et inférieure (2) étant en silicium fortement dope de même type de conductivité que le silicium du matériau semiconducteur.

7. Le composant semiconducteur de la revendication 6, dans lequel l'électrode inférieure (2) est constituée par le substrat même du composant.

8. Le composant semiconducteur de la revendication 1, dans lequel l'électrode inférieure (2) est formée par une couche épitaxiée sur un substrat de silicium quasi-intrinsèque de forte résistivite (1), des moyens (33) étant alors prévus pour assurer la prise de contact à l'électrode inférieure au travers de ce substrat de forte résistivité.

9. Le composant semiconducteur de la revendication 1, comprenant en outre des circuits de préadaptation d'impédance d'entrée (35), formés par une combinaison de sections inductives (36) et de sections capacitives (37) des conducteurs de liaison aux différents doigts conducteurs constituant l'électrode de commande du composant ainsi que, le cas écheant, d'une combinaison de sections inductives (36) et de sections capacitives (37) des conducteurs d'interconnexion des électrodes de commande d'autres composants réalises sur le même substrat, de manière à compenser la désadaptation d'impédance résultant de la mise en parallèle des différents doigts conducteurs d'un même composant et/ou la désadaptation d'impédance résultant de la mise en parallèle de plusieurs composants réalisés sur le même substrat.

10. Le composant semiconducteur de la revendication 1, comprenant en outre des circuits de préadaptation d'impédance de sortie (34), formés par une combinaison de sections inductives et de sections capacitives des conducteurs de liaison aux difféerentes plages conductrices constituant l'électrode supérieure du composant ainsi que, le cas échéant, d'une combinaison de sections inductives (39) et de sections capacitives (40) des conducteurs d'interconnexion des électrodes supérieures d'autres composants réalisés sur le même substrat, de manière à compenser la désaptation d'impédance résultant de la mise en parallèle des différentes différentes plages conductrices d'un même composant et/ou la désadaptation d'impédance résultant de la mise en parallèle de plusieurs composants réalisés sur le même substrat.

11. Un procédé de réalisation d'un composant à jonction Schottky selon l'une des revendications précédentes, comprenant les étapes consistant à:
    (a) former sur un substrat (1 ; 2) une structure en superposition comprenant successivement une électrode inférieure (2), une couche de matériau semiconducteur (3) et une électrode supérieure (4),
    (b) graver dans cette structure des tranchées (7) de profondeur telle qu'elles entament au moins partiellement l'épaisseur de l'électrode inférieure,
    (c) remplir les tranchées ainsi formées par un matériau isolant (20),
    (d) éliminer partiellement le matériau isolant ainsi de pose jusqu'à une profondeur de tranchée située à un niveau médian de la couche de matériau semiconducteur,
    (e) déposer dans la tranchee, sur la région apparente du matériau isolant audit niveau médian, une métallisation (21, 25) formant électrode de commande, et
    (f) passiver les flancs de la tranchée au-dessus de la métallisation ainsi déposée.

12. Le procédé de la revendication 11, dans lequel l'étape (f) ci-dessus comprend les étapes consistant à:
    (f1) déposer, sur les flancs et le fond de la tranchée, au moins une couche de matériau de passivation (23),

(f2) graver sélectivement les zones horizontales de cette couche de matériau de passivation, de manière à laisser paraître au fond de la tranchée la métallisation (21) sous-jacente,

(f3) déposer sur cette métallisation apparente une couche de matériau d'enrichissement métallique (25).

13. Le procédé de la revendication 12, dans lequel:
   – au cours de l'étape (f1), on dépose successivement un premier (23) puis un second (24) matériau de passivation, différent du premier, et
   – après l'étape (f3), il est prévu une étape (f4) consistant à éliminer le second matériau de passivation (24) de manière à laisser subsister, entre les flancs de la tranchée et les flancs dudit matériau d'enrichissement métallique, un intervalle (27) depourvu de matériau.

14. Le procédé de la revendication 11, dans lequel ledit matériau isolant (20) est un matériau du groupe comprenant les polyimides, l'oxyde de silicium, le nitrure de silicium et l'oxynitrure de silicium.

15. Le procédé de la revendication 11, comprenant également, après l'étape (f), des étapes consistant à:
   (g) remplir à nouveau les tranchées par un matériau isolant (28),
   (h) éliminer partiellement le matériau isolant ainsi déposé jusqu'à une profondeur de tranchée située à un niveau intermédiaire entre ledit niveau médian de la couche de matériau semiconducteur et le niveau de l'électrode supérieure,
   (i) déposer dans la tranchée, sur la région apparente du matériau isolant audit niveau intermédiaire, une seconde métallisation (29) formant électrode d'écran.

16. Le procédé de la revendication 11, dans lequel :
   – ladite structure est une structure formée par épitaxie de silicium, ledit matériau semiconducteur (3) étant faiblement dope, et les électrodes supérieure (4) et inférieure (2) étant fortement dopées et de même type de conductivité que ledit matériau semiconducteur, et
   – l'électrode inférieure (2) est constituée par le substrat même du composant.

17. Le procédé de la revendication 11, dans lequel ladite structure est une structure formée par épitaxie de silicium sur un substrat de silicium quasi-intrinsèque de forte résistivité (1), ledit matériau semiconducteur (3) étant faiblement dopé, et les électrodes supérieure (4) et inférieure (2) étant fortement dopées et de même type de conductivité que ledit matériau semiconducteur (3).

18. Le procédé de la revendication 17, comprenant en outre des étapes consistant à:
   – former au dos du substrat des vias sur une profondeur permettant d'atteindre l'électrode inférieure, et
   – déposer dans ces vias une métallisation (33) permettant d'assurer la prise de connexion à cette électrode.

19. Le procédé de la revendication 11, comprenant en outre une étape de gravure sélective des métallisations formant les électrodes de commande, de manière à former une combinaison de sections inductives (36) et de sections capacitives (37) de ces électrodes de commande ainsi que, le cas échéant, une combinaison de sections inductives (36) et de sections capacitives (37) des conducteurs d'interconnexion des électrodes de commande d'autres composants réalisés sur le même substrat.

20. Le procédé de la revendication 11, comprenant en outre une étape de gravure sélective des métallisations formant les électrodes supérieures, de manière à former une combinaison de sections inductives et de sections capacitives des conducteurs de liaison de ces électrodes supérieures ainsi que, le cas écheant, une combinaison de sections inductives (39) et de sections capacitives (40) des conducteurs d'interconnexion des électrodes supérieures d'autres composants réalises sur le même substrat.

FIG.1

FIG.5

FIG.2

FIG.3

FIG.4

FIG.6.

FIG.7

FIG.8

FIG.9

FIG.10

FIG.11

FIG.12

FIG.13

FIG.14

FIG.15

FIG.16

FIG.17

FIG.18

FIG.19

FIG.20

FIG.21

FIG.22

FIG.23

FIG.24

FIG.25

FIG.26

FIG.27

FIG.28

FIG.29

FIG.30